# EUROPEAN PATENT APPLICATION

(11) **EP 3 057 127 A1**
(43) Date of publication of application: **17.08.2016**
(21) Application number: 16155479.5
(22) Date of filing: 12.02.2016
(51) Int. Cl.: H01L 23/31, H01L 23/66

(54) **RF PACKAGE**

(30) Priority: 12.02.2015 US 201514620575
(71) Applicant: Ampleon Netherlands B.V., 6534 AV Nijmegen (NL)
(72) Inventor: Weinschenk, Christian, 6534 AE NIJMEGEN (NL); Mavinkurve, Amar Ashok, 6534 AE NIJMEGEN (NL)
(74) Representative: Nollen, Maarten Dirk-Johan

(57) **Abstract**

An example package comprising: an RF circuit; a non-gaseous dielectric material coupled to the RF circuit, and having a thickness based on a magnetic field in the RF circuit; and an encapsulant material coupled to cover the RF circuit and non-gaseous dielectric material on at least one side of the RF circuit. An example method of package manufacture, comprising: identifying an RF circuit; dispensing a non-gaseous dielectric material upon the RF circuit, wherein at least a portion of the non-gaseous dielectric material has a thickness based on a magnetic field in the RF circuit; and covering the RF circuit and non-gaseous dielectric material with an encapsulant material on at least one side of the RF circuit.

## Description

### Field of the invention

The invention relates to a package comprising an RF circuit and an encapsulation to cover the RF circuit.

The invention further relates to a method of manufacturing such an RF circuit.

### Background of the invention

As electrical circuits and devices are reduced in size, resistance and capacitive coupling increase, causing an increase in signal delay (i.e. RC delay) and other electrical losses. This becomes an increasing problem as an electrical circuit's operating frequency increases (e.g. for RF circuits and devices) which further limits the circuit's performance.

RF circuits that are particularly sensitive for losses of RF performance are RF power amplifiers. These RF power amplifiers typically contain a semiconductor die with active elements, such as transistors. The power amplifier may further contain impedance matching components, such as capacitors and/or inductive elements, for matching the impedance at an output of the transistor. While typically the amplifier contains several parts, it may be that the amplifier is functionally a single element. It is further feasible that the amplifier comprises several stages.

The transistor design of an RF power amplifier is optimized for use at high frequencies, for instance above 1GHz and suitably extending in the range up to 3 GHz and higher and also at relatively high power levels. Such a power transistor may be a field effect transistor or a bipolar transistor and is made in technologies such as Si LDMOS, GaN or GaAs. Typically, a first and a second electrode, for instance drain and gate, are implemented as a plurality of elongated bars that are arranged in parallel. A third electrode, which is for instance the source, is coupled to the substrate and an underlying substrate contact. The number of elongated bars may be significant, for instance in the range of 10-300, for instance 30-250, typically 50 or more or 100 or more. The elongated bars of are typically coupled via internal wiring to bond pads that are arranged at a top side of the semiconductor die and in the outer ring thereof. These bond pads are exposed through an opening in a passivation layer. While many integrated circuits contain many internal wirings that are present in several interconnect layers, the number of interconnect layers is typically limited to 1 or 2 in RF power amplifiers, due to the fact that there is only limited interconnection and that the effective feature size of the RF transistor is relatively big so as to enable sufficient heat dissipation.

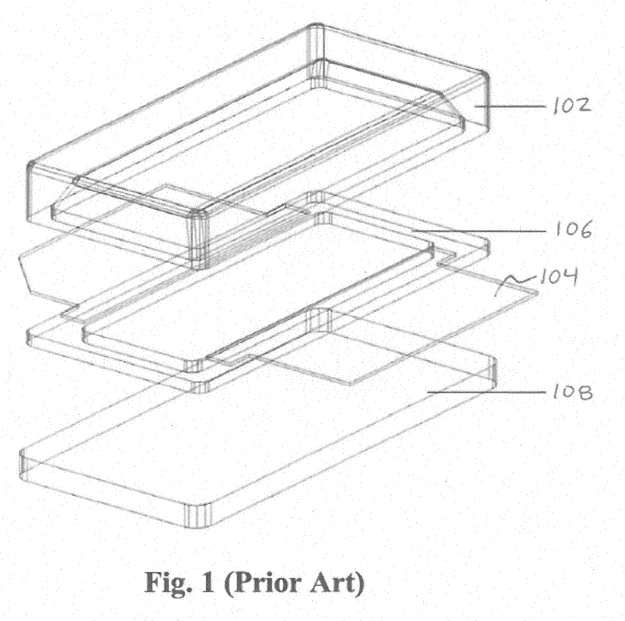

Traditionally, RF power amplifiers are present in air cavity package 100 as shown in Figure 1. The package 100 includes a lid with open cavity 102, a lead frame 104, a dielectric ring 106 and a heat sink 108. The air cavity package 100 is built-up by stacking these elements, which thereby encapsulate a semiconductor die, internal wiring and an air cavity. Epoxy glues are used to hold these elements together. More particularly, the semiconductor die is attached with its bottom side to the heat sink. Bond pads are present at a top side of the semiconductor die. Bond wires extend between the bond pads and individual leads of the leadframe 104.

The function of the air cavity is to provide a robust package on top of the RF die. Because of the absence of any encapsulant, the thermal stability of such encapsulant during operation of the power amplifier is not an issue. Furthermore, air is a dielectric with low dielectric constant (e.g. *k* close 1.0). As a consequence, interaction between the wire loops of bond wires can be minimized. Hence, the wire loops can be designed and used as part of an input shunt inductance and/or as part of an output circuit for impedance matching. Thus all-in-all reduces electrical losses and enhances the performance of the RF product and system. The dielectric constant (k) is a measure of how easily a material is polarized in an external electric field.

A disadvantage of the known air cavity package is the use of a dielectric ring and lid. The dielectric ring (106) should be fixed to the heat sink (108) before wire bonds are provided. The lid should be fixed to the package after that bond wires are provided. The placement and attachment is cumbersome at that stage, resulting in a high cost. Furthermore, the lid can be removed easily by clients or users. That removal may result in malfunctioning of the RF circuit, which is not desired.

As an alternative to the use of an air cavity package with a lid, it is known to apply an encapsulant by moulding. The RF circuit becomes fully encapsulated in the moulded encapsulant (also known as a moulding compound). Merely the leads and the heatsink are present at the outside of the package. This type of package is very well known in the field of semiconductor packaging and further provides a very good protection against humidity, dust and environmental conditions. However, a moulding compound typically includes fillers such as glass fibers, which contribute to the dielectric constant of the package material, which is undesired for the performance of the RF circuit.

### Summary

It is therefore an object of the invention to provide an improved package that has a good RF performance, but does not have the drawbacks of the traditional air cavity package. It is a further object of the invention to provide a robust method of manufacturing such a package.

According to a first example embodiment, a package includes: an RF circuit; a non-gaseous dielectric material coupled to the RF circuit, and having a thickness based on a magnetic field in the RF circuit; and an encapsulant material coupled to cover the RF circuit and non-gaseous dielectric material on at least one side of the RF circuit.

In a further embodiment, the dielectric material is a low-k dielectric material, preferably having a relative dielectric constant of 3 or less, more preferably 2.5 or less or even 2 or less. Suitably, a dielectric constant of the dielectric material is less than a dielectric constant of the encapsulant material. Examples of materials include BCB, with a relative dielectric constant of 2.7, AL-X commercially available from AGC, with a dielectric constant of 2.7. A further option is the use of a conventional packaging material, such as an epoxy with a porous filler, such as a porous silica. In one implementation, the silica pores may be filled with a sacrificial material that can be removed by outgassing at higher temperatures of for instance 130°C. Alternative porous fillers such as porous (fumed) alumina, porous carbon doped silicon oxide may also be applied. The advantage of using a conventional packaging material with porous fillers is that the adhesion between the dielectric material and the encapsulant is good. Alternatively, use is made of a porous organic polymer material, for instance a foamed organic polymer material. In again a further example, a low-K dielectrics used for interconnect structures may be provided, and particularly dispensed within a wall-shaped structure. Such a material may thereafter, if so desired be covered with a further passivation layer, for instance of silicon oxide or silicon nitride, so as to achieve sufficient adhesion to the moulding compound. Such a structure of a wall-shaped structure filled with a porous material, and an subsequent passivation layer may also be provided on wafer level, i.e. prior to dicing a substrate into individual dies and prior to opening the passivation layer so as to expose underlying bond pads.

In another example embodiment, the circuit includes active elements and passive elements. The passive elements may be integrated in the semiconductor die or be assembled as discrete components or be integrated in a separate die based on a semiconductor material. Suitably, the dielectric material does not cover all of the passive elements. More particularly, the semiconductor die contains an outer ring provided with bond pads, and an inner area within the outer ring. Herein, the dielectric material is present on top of the inner area, while the outer ring is left free of dielectric material. In this manner, it is enabled that the dielectric material does not get into contact with the bond wires. Such a contact would give rise to an interface between the encapsulant (particularly a moulding compound) and the dielectric material at the bondwire. The difference in thermal expansion may give rise to stress and strain on the bond wire, which could lead to failure. If passive elements such as capacitors are integrated in the semiconductor die, these may be present, at least partially, in the outer ring, and partially in the inner area, so that the dielectric material does not cover all of the passive elements.

In one further embodiment, a wall-shaped structure is present on top of the semiconductor die, laterally around the inner area, when seen in a perpendicular top view on the semiconductor die, but within the outer ring. The wall shaped structure is suitably made of dielectric material, and preferably of a dielectric material with a relatively low dielectric constant, for instance a relative dielectric constant of less than 4, preferably less than 3. This wall-shaped structure creates a cavity in which the low-K dielectric material can be provided up to a sufficient thickness. It was found that even when this wall-shaped structure partially overlaps, when seen in a perpendicular projection on the semiconductor die, with the elongated bars of the power transistor(s), the performance losses is comparatively small.

In one particular embodiment, the dielectric material is provided in a thickness of at least 20 µm, and more preferably up to 100µm, for instance 25-50µm. It has been found that the magnetic field in the package may extend to such a height, particularly when the RF frequencies of operation are larger than 1 GHz, and more particularly from 1.8 GHz and higher. For such frequencies, moreover the performance losses due to the interaction in the magnetic field with the dielectric material of a conventional moulding compound have found to be so significant that they will have an impact on the RF performance. Therefore, the provision of a dielectric material with a suitable thickness of at least 20 µm reduces the performance losses to an acceptable level.

In again a further embodiment the RF package further includes a lead-frame and a set of bond-wires; and in such embodiment, a first bond-wire couples the circuit to the lead-frame; the dielectric material completely covers a second bond-wire; and the encapsulant further covers the first bond-wire, the second bond-wire and a portion of the lead-frame. Therewith, it is achieved that the overall package is mechanically robust.

Another example first embodiment further includes a second circuit completely covered by the dielectric material; and in such embodiment, the second bond-wire couples the RF circuit to the second circuit.

In another example embodiment, the RF circuit includes a device operating at a frequency of at least 1GHz.

In another example embodiment, the circuit is a semiconductor die. In another example embodiment, the encapsulant material is coupled to encapsulate the RF circuit and non-gaseous dielectric material.

According to a second example embodiment, a package includes: an RF circuit having a first portion and a second portion; a non-gaseous dielectric material coupled only to the first portion of the RF circuit; and an encapsulant material coupled to cover the RF circuit and non-gaseous dielectric material on at least one side of the RF circuit.

According to a first example method of package manufacture, the method includes: identifying an RF circuit; dispensing a non-gaseous dielectric material upon the RF circuit, at least a portion of the non-gaseous dielectric material has a thickness based on a magnetic field in the RF circuit; and covering the RF circuit and non-gaseous dielectric material with an encapsulant material on at least one side of the RF circuit.

In another example method embodiment, the non-gaseous dielectric material is dispensed upon the RF circuit after the RF circuit has been diced and affixed to a substrate. In another example method embodiment, the non-gaseous dielectric material is dispensed upon the RF circuit after bond-wires have coupled the RF circuit to a lead-frame.

In another example method embodiment, the circuit includes active elements and passive elements; the dielectric material does not cover all of the passive elements; and the encapsulant material does cover all of the active and passive elements.

In another example method embodiment, the dielectric material is dispensed as a liquid. This is deemed a beneficial way of applying the dielectric material in a sufficient thickness. The dispensing may occur in several rounds, each comprising a dispensing step and a first curing step, so as to dry and stabilize the dielectric material.

In another example method embodiment, a dielectric constant of the dielectric material is less than a dielectric constant of the encapsulant material.

In another example method embodiment, the thickness of the dielectric material is greater than 20µm.

Various example embodiments may be more completely understood in consideration of the following Detailed Description in connection with the accompanying Drawings, in which:

### Brief description of the drawings

Figure 1 is an air cavity package.
Figure 2 shows a first example RF package.
Figure 3 shows an encapsulated version of the first example RF package.
Figure 4 shows a second example RF package.
Figure 5 shows a third example RF package.
Figure 6 shows a fourth example RF package.
Figures 7A and 7B show a fifth example RF package.
Figure 8 is an example method for fabricating an RF package.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

### Detailed description

In RF systems, semiconductor packages for RF amplifiers or RFIC's can be made by means of over-molding such that the dies and wires are covered by mold compound. Examples of this art are the QFN, HSOP and BGA package styles.

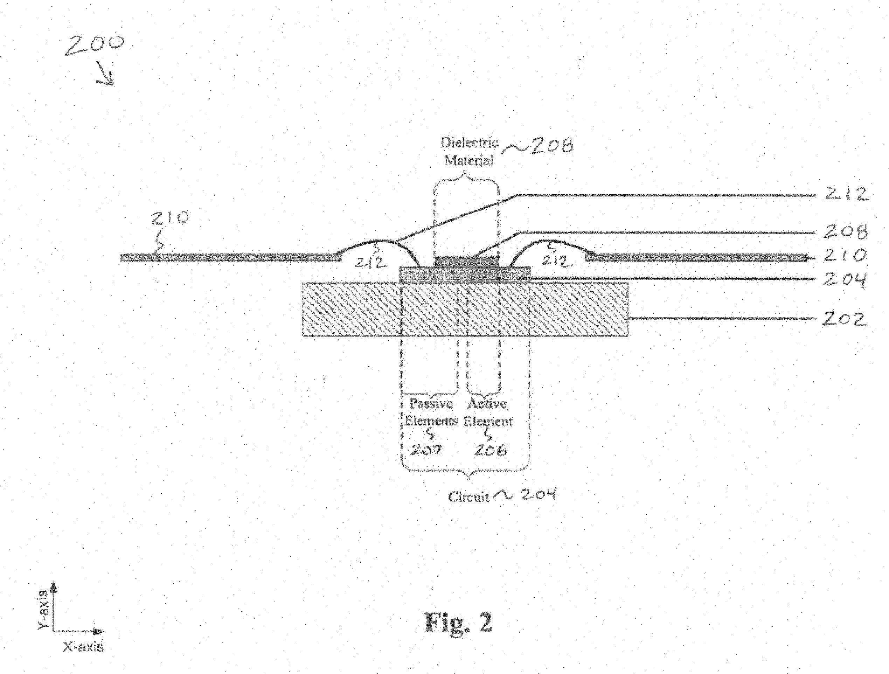

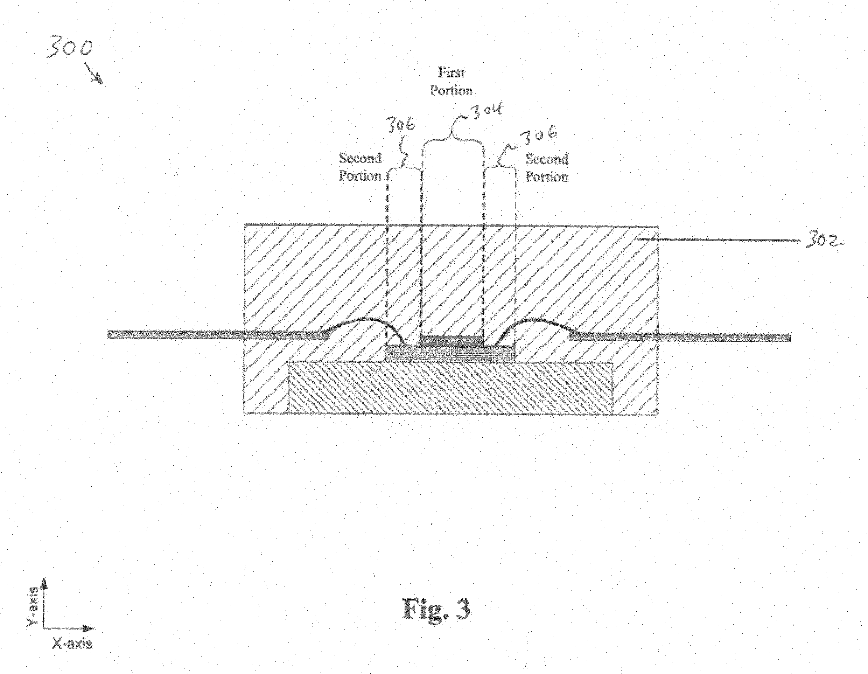

Figure 2 shows a first example RF package 200. Figure 3 shows an encapsulated version 300 of the first example RF package 200. Figures 2 and 3 will be discussed together.

The RF circuit package 200 includes a substrate 202 (e.g. heat sink) upon which a circuit 204 (e.g. die) is affixed (e.g. bonded). In one example, the circuit 204 includes one or more active elements 206 and passive elements 207. A dielectric material 208 (e.g. an insert made of a low-k dielectric) is placed over at least one of the active elements 206. The circuit 204 is connected to a lead-frame 210 by one or more bond-wires 212. In one example an encapsulant material 302 (e.g. molding compound) covers the entire circuit 204, dielectric material 208, bond-wires 212 and at least part of the lead-frame 210. In other examples, the encapsulant material 302 may cover only part of the circuit 204, dielectric material 208 and bond-wires 212. When the encapsulant material 302 covers these element, such covering may include encapsulating one or more of these elements.

In another example embodiment, the package 200 includes: the RF circuit 204; a non-gaseous dielectric material 208 coupled to the RF circuit 204, having a lateral thickness based on a magnetic field in the RF circuit; and an encapsulant material 302 coupled to cover the RF circuit 204 and non-gaseous dielectric material 208 on at least one side of the RF circuit 204.

In various examples: the dielectric material 208 can be a low-k dielectric material 208; a dielectric constant of the dielectric material 208 is less than a dielectric constant of the encapsulant material 302; the circuit 204 includes active elements 206 and passive elements 207; or the dielectric material 208 does not cover all of the passive elements 207, but may cover some or all of the active elements 206.

The function of the dielectric material 208 is to provide a low dielectric constant (as close to 1.0 as possible) over one or more active elements 206 in the circuit 204. In one example embodiment, the dielectric constant of the dielectric material 208 is lower than that of the encapsulant material 302 (3.5-4.0), perhaps lower than 2.

The material can consist of a porous or non-porous type of dielectric material 208 with composition and viscosity such as to enable dispensing an appropriate height for the device (e.g. ranging from 20µm to 100µm). However in other embodiments, the height of the dielectric material 208 can be less than 20µm, or thicker than 100µm. Thicker coatings of the dielectric material 208 further reduce electrical losses due to electrical fields created by the RF circuit and associated circuit leads and/or bond-wires 212. The longitudinal dimensions of the dielectric material 208 depend on the area of the active elements 206, the passive elements 207 and the circuit 204 being covered.

The dielectric material 208 can be locally dispensed just onto one or more of the elements 206, 207 or circuits 204, before or after the circuits 204 are attached (e.g. bonded) to the substrate 202. Such dispensing could be as a glob-top or as a spray.

The phrase "active element" 206 can have different meanings, but in this case at least refers to amplification elements, including transistors or mosfets and any other amplification device.

"Passive elements" 207 are hereby defined as any other electrical element which is not an active element 206 (e.g. capacitors, resistors, inductors, bond-wire 212 pads, wires, etc.)

To reiterate, the dielectric material 208 can be placed just on top of the active elements 206; placed on top of both active elements 206 and passive elements 207; or also placed on the bond-wires 212 to reduce electrical losses even further and thereby further enhance the performance of the RF device.

Other examples further include a lead-frame 210 and a set of bond-wires 212. Then: a first bond-wire 212 couples the circuit 204 to the lead-frame 210; the dielectric material 208 covers or partially covers a second bond-wire 212; and the encapsulant material 302 further covers the first bond-wire 212, the second bond-wire 212 and a portion of the lead-frame 210.

In example embodiments having a second circuit 204, the second bond-wire 212 couples the RF circuit 204 to the second circuit 204. In such examples having multiple circuits 202, such circuits 204 may be interconnected with bond-wires 212 and placed within a single lead-frame 210. In such an example, not all of the package's 200 bond-wires 212 may be coupled to the lead-frame 210, since some of the bond-wires 212 are interconnecting the different circuits 204 within the package 200.

The RF circuit 204 can be a device operating at a frequency of at least 1GHz, but in some example may be as low as 100MHz. The circuit 204 may also be wholly embodied in a semiconductor die.

The encapsulant material 302 can be coupled to encapsulate the RF circuit 204 and non-gaseous dielectric material 208. Figure 3 shows an example where the substrate 202 could be a heat-sink, one side of which is left exposed for effective circuit 204 cooling, and the other sides covered by the encapsulant material 302.

Alternate example embodiments of the package 200 can include: an RF circuit 204 having a first portion 304 and a second portion 306; a non-gaseous dielectric material coupled only to the first portion of the RF circuit 204; and an encapsulant material 302 coupled to cover the RF circuit 204 and non-gaseous dielectric material on at least one side of the RF circuit 204.

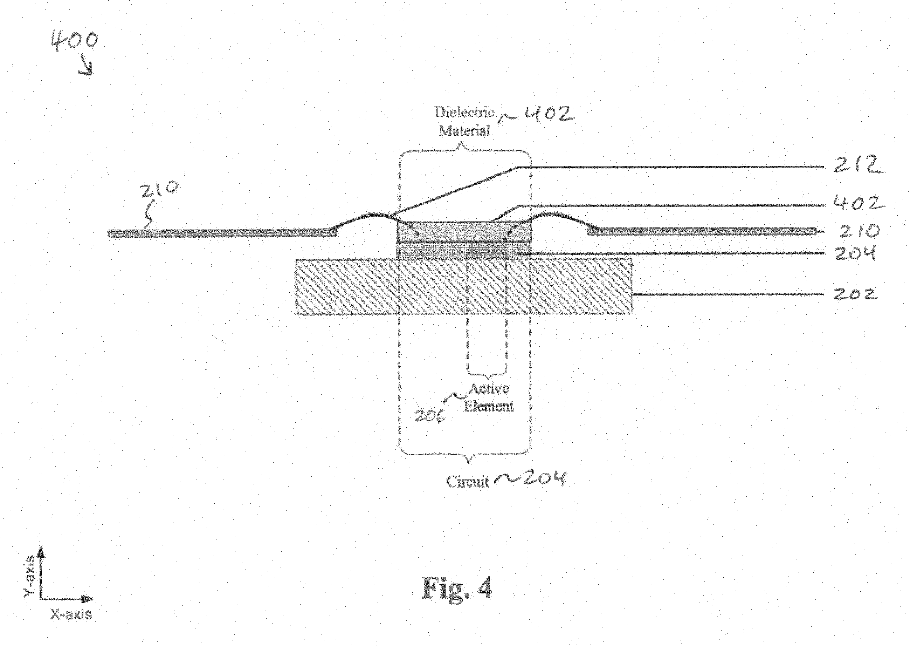

Figure 4 shows a second example RF package 400. In this example a dielectric material 402 covers an entire surface of the circuit 204, including both the active elements 206 and passive elements (i.e. the remainder of the circuit 204 which may include empty areas with no electrical or mechanical elements). Encapsulant would then be applied to cover all or part of the dielectric material 402, the circuit 204, the substrate 202, the bond-wires 212 and the lead-frame 210.

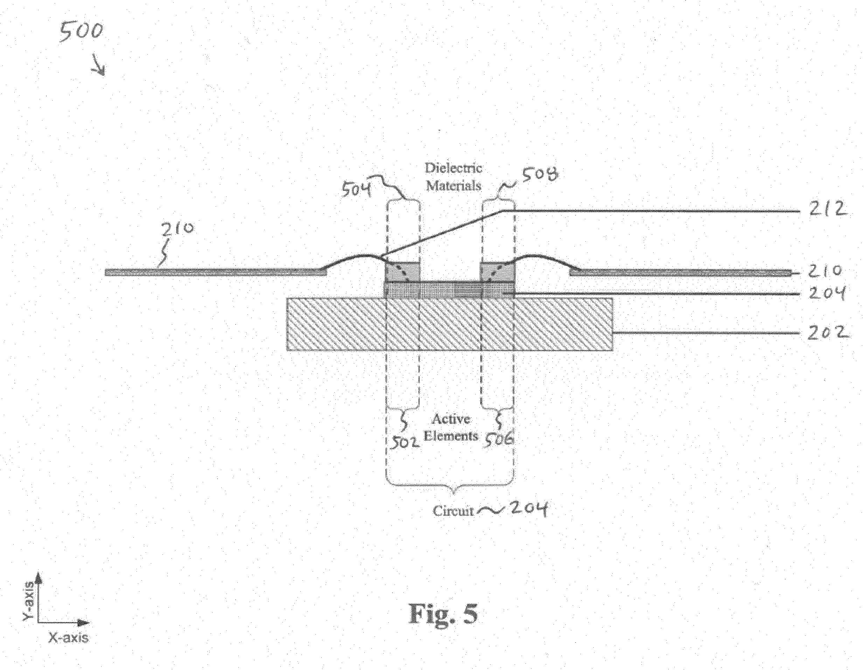

Figure 5 shows a third example RF package 500. The package 500 includes a first active element 502, covered by a first dielectric material 504, and a second active element 506, covered by a second dielectric material 508. The remainder of the circuit 204 may or may not include additional active or passive elements. Encapsulant would then be applied to cover all or part of the dielectric materials 504, 508, the circuit 204, the substrate 202, the bond-wires 212 and the lead-frame 210.

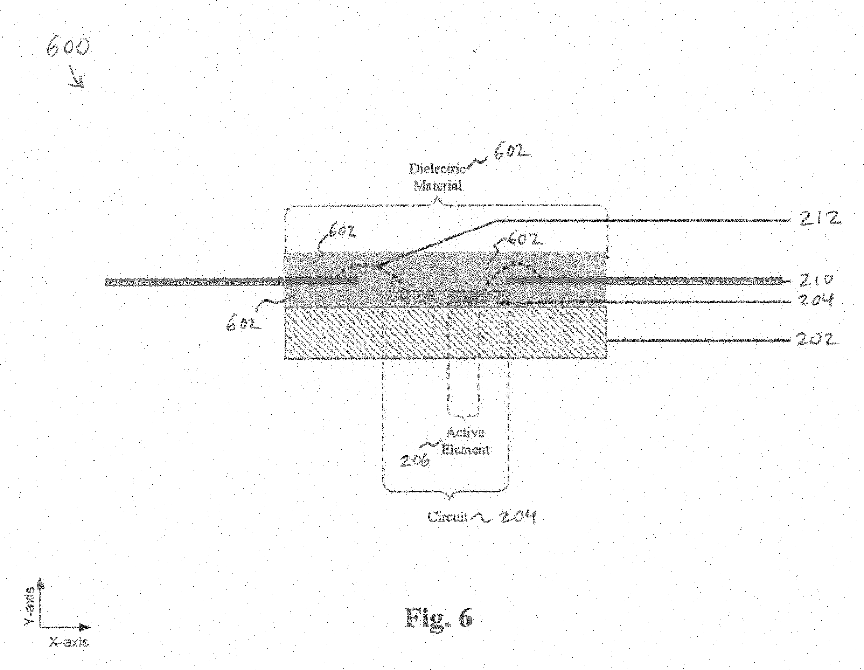

Figure 6 shows a fourth example RF package 600. In this example a dielectric material 602 covers not only an entire surface of the circuit 204, but also the entire substrate 202, the bond-wires 212 and a portion of the lead-frame 210. Encapsulant would then be applied to cover all or part of the dielectric material 602, the substrate 202 and lead-frame 210.

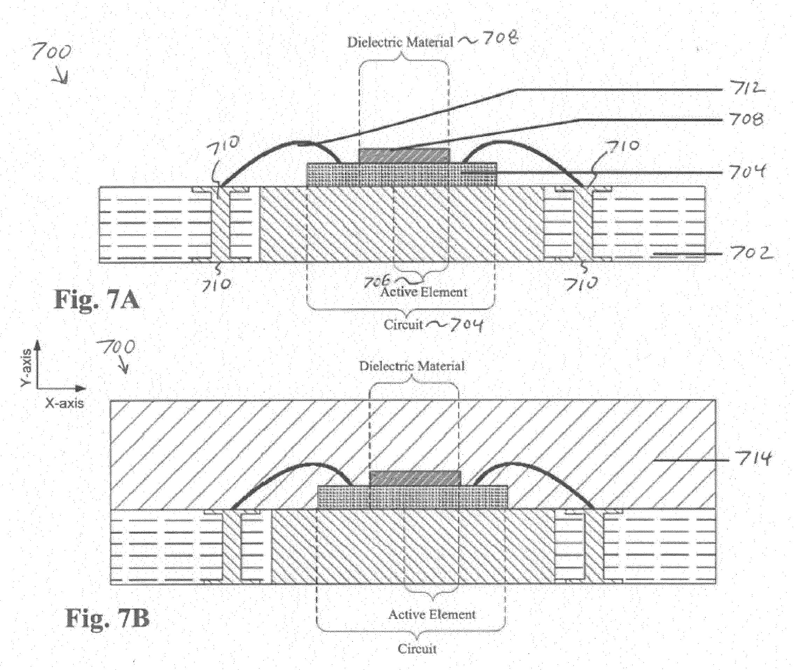

Figures 7A and 7B show a fifth example RF package 700. The package 700 includes a laminate 702 upon which a circuit 704 is affixed. In one example, the circuit 704 includes one or more active elements 706 and passive elements. A dielectric material 708 is placed over at least one of the active elements 706. The circuit 704 is connected to one or more terminals 710 (e.g. pin, via or contact) by one or more bond-wires 712. In one example an encapsulant material 714 covers the entire circuit 704, dielectric material 708, bond-wires 712 and at least one of the terminals 710. In other examples, the encapsulant material 714 may cover only part of the circuit 704, dielectric material 708 and bond-wires 712. The laminate 702 can be an organic material based substrate.

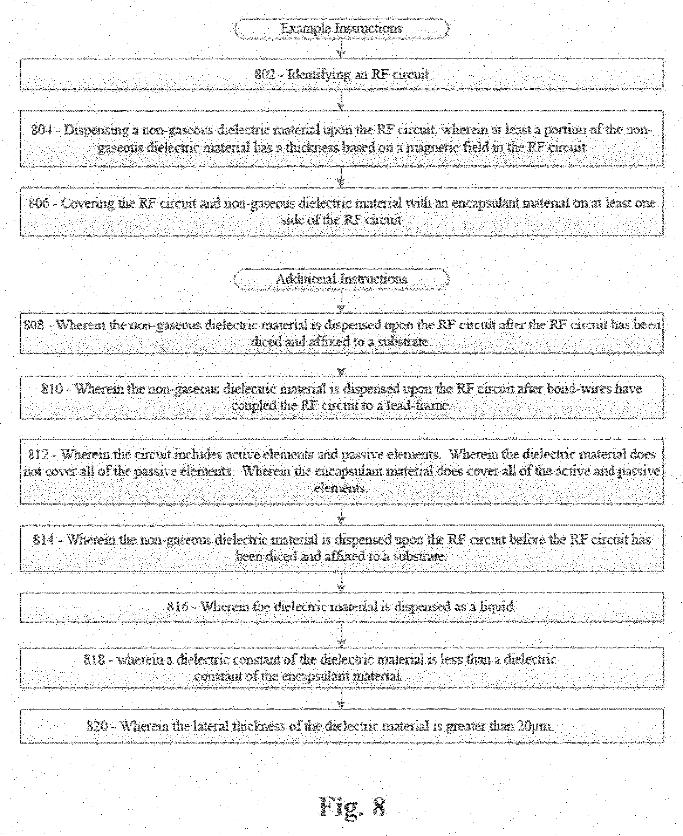

Figure 8 is an example method for fabricating an RF package. The order in which the instructions are discussed does not limit the order in which other example embodiments implement the instructions. Additionally, in some embodiments the instructions are implemented concurrently.

A first example instruction begins in 802, by identifying an RF circuit. Next, in 804, dispensing a non-gaseous dielectric material upon the RF circuit, wherein at least a portion of the non-gaseous dielectric material has a thickness based on a magnetic field in the RF circuit. Then in 806, covering the RF circuit and non-gaseous dielectric material with an encapsulant material on at least one side of the RF circuit.

The instructions can be augmented with one or more of the following additional instructions, presented in no particular order. The additional instructions include: 808 - wherein the non-gaseous dielectric material is dispensed upon the RF circuit after the RF circuit has been diced and affixed to a substrate. 810 - wherein the non-gaseous dielectric material is dispensed upon the RF circuit after bond-wires have coupled the RF circuit to a lead-frame. 812 - wherein the circuit includes active elements and passive elements; wherein the dielectric material does not cover all of the passive elements; and wherein the encapsulant material does cover all of the active and passive elements. 814 - wherein the non-gaseous dielectric material is dispensed upon the RF circuit before the RF circuit has been diced and affixed to a substrate. 816 - wherein the dielectric material is dispensed as a liquid. 818 - wherein a dielectric constant of the dielectric material is less than a dielectric constant of the encapsulant material. 820 - wherein the lateral thickness of the dielectric material is greater than 20µm.

The instructions and/or flowchart steps in the above Figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions described above are implemented as functional and software instructions embodied as a set of executable instructions in a non-transient computer-readable or computer-usable media which are effected on a computer or machine programmed with and controlled by said executable instructions. Said instructions are loaded for execution on a processor (such as one or more CPUs). Said processor includes microprocessors, microcontrollers, processor modules or subsystems (including one or more microprocessors or microcontrollers), or other control or computing devices. A processor can refer to a single component or to plural components. Said computer-readable or computer-usable storage medium or media is (are) considered to be part of an article (or article of manufacture). An article or article of manufacture can refer to any manufactured single component or multiple components. The non-transient machine or computer-usable media or mediums as defined herein excludes signals, but such media or mediums may be capable of receiving and processing information from signals and/or other transient mediums.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A package comprising:
an RF circuit;
a non-gaseous dielectric material coupled to the RF circuit, and having a thickness based on a magnetic field in the RF circuit; and
an encapsulant material coupled to cover the RF circuit and non-gaseous dielectric material on at least one side of the RF circuit.

2. The package of claim 1,
wherein the dielectric material is a low-k dielectric material, and wherein preferably a dielectric constant of the dielectric material is less than a dielectric constant of the encapsulant material.

3. The package of claim 1 or 2,:wherein the circuit includes active elements and passive elements; and wherein the dielectric material does not cover all of the passive elements.

4. The package of any of the claims 1-3, wherein the RF circuit is at least embodied on a semiconductor die having an inner area and an outer ring, wherein the die is at a top side in the outer ring provided with bond pads, and wherein the dielectric material is arranged on top of the inner area.

5. The package of claims 1-4, wherein the dielectric material is applied in a thickness of at least 20 µm.

6. The package of claims 1-5, wherein the RF circuit includes a device operating at a frequency of at least 1GHz.

7. The package of claims 1-6, wherein the circuit is a semiconductor die

8. The package of claim 7, wherein preferably at least one power transistor is defined having a plurality of elongated electrode bars arranged in parallel.

9. The package of claim 1, wherein the encapsulant material is coupled to encapsulate the RF circuit and non-gaseous dielectric material.

10. A method of package manufacture, comprising:
identifying an RF circuit;
dispensing a non-gaseous dielectric material upon the RF circuit, wherein at least a portion of the non-gaseous dielectric material has a thickness based on a magnetic field in the RF circuit; and
covering the RF circuit and non-gaseous dielectric material with an encapsulant material on at least one side of the RF circuit.

11. The method of claim 10, wherein the non-gaseous dielectric material is dispensed upon the RF circuit after the RF circuit has been diced and affixed to a substrate.

12. The method of claim 11, wherein the non-gaseous dielectric material is dispensed upon the RF circuit after bond-wires have coupled the RF circuit to a lead-frame.

13. The method of claim 10-12, wherein the dielectric material is dispensed as a liquid.

14. The method of claim 10-13, wherein a dielectric constant of the dielectric material is less than a dielectric constant of the encapsulant material.

15. The method of claim 12, wherein the thickness of the dielectric material is greater than 20µm.
